# EUROPEAN PATENT SPECIFICATION

(11) **EP 3 884 520 B1**
(45) Date of publication and mention of the grant of the patent: **22.05.2024**
(21) Application number: 19809887.3
(22) Date of filing: 21.11.2019
(51) Int. Cl.: H01L 23/473, H05K 7/20

(54) **COOLING SYSTEM**
KÜHLSYSTEM
SYSTÈME DE REFROIDISSEMENT

(30) Priority: 21.11.2018 GB 201818946
(43) Date of publication of application: 29.09.2021
(73) Proprietor: McLaren Applied Limited, Woking Surrey GU21 6JD (GB)
(72) Inventor: DE SOUSA, Luis Manuel, Surrey GU21 4YH (GB); MARLOW, David, Surrey GU21 4YH (GB); NANAKOS, Anastasios, Surrey GU21 4YH (GB)
(74) Representative: Slingsby Partners LLP
(86) International application number: PCT/GB2019/053295
(87) International publication number: WO 2020/104805

(56) References cited:
- WO-A1-2019/180762
- DE-A1-102015 225 645
- JP-A- 2017 174 991
- US-A1- 2014 140 117
- US-A1- 2014 158 324

## Description

This invention relates to cooling system for power electronics and, in particular, a cooling system that has a low pressure drop and/or a reduced temperature gradient.

It is well known that electronic circuits generate heat during use. This is particularly true in electrical circuits that transmit and/or convert power because as the electrical power that passes through a circuit increases, the heat that is generated typically increases. Despite the ever increasing efficiency of such circuits and especially within high power electronic converters using in the order of tens to hundreds of kilowatts, the power losses through heat, typically a few kilowatts, need to be dissipated or otherwise removed. This is to avoid degradation or other damage to the circuitry, power modules or other components, and to avoid thermal runaway which occurs in situations where an increase in temperature changes the conditions in a way that causes a further increase in temperature, often leading to a destructive result. It is a kind of uncontrolled positive feedback.

Initially, air cooled systems were sufficient to dissipate the amount of heat generated, but increasingly these are found to lack the capacity. As such, water cooled systems are preferred and, even more preferred, direct water cooling is used to avoid multiple layers of thermal interfaces. High power electronic converters typically comprise a series of individual power modules in which power is converted, and these power modules are typically soldered or otherwise bonded directly to a plate equipped with pin fins which can contact the cooling fluid, typically water, directly.

Conventional water cooling systems generally provide a flow of cooling water through a chamber into which the pin fins extend, thereby allowing the water to take up heat generated from the power modules mounted on the opposite face of the chamber wall to the pin fins. This however leads to a temperature gradient over the chamber, as the inlet water is cooler than the outlet water, and this can lead to insufficient cooling of components nearer the outlet or unwanted hot spots on the power modules. Such hotspots can lead to reduce performance of the electronics or even damage or failure of components. When the thermal gradient is too high, this can lead to material fatigue, especially when the power modules are subjected to thermal and/or power cycling.

One solution is to increase the flow rate of the cooling water, thereby ensuring appropriate levels of cooling, but this comes at the cost of an increased pressure drop. The pressure drop is caused by the resistance to flow of the pin fins, such that as the fin density/fin size increases so does the pressure drop. Also, the inlet and outlet flow restrictions necessarily cause a pressure drop.

Thus, conventional direct water cooled systems are relatively heavy and large in comparison to the power modules which are to be cooled, and this size makes them difficult to integrate into larger systems, especially hybrid cars for example, where space is limited.

Furthermore, when such a cooling system is required in a racing vehicle, the size and weight of componentry can drastic affect the overall performance of the vehicle. Thus, it is desirable to improve the cooling system to avoid or at least reduce one or more of the problems identified above.

DE 102015225645 A1 describes a cooling device for cooling power electronics. US 2014/0158324 A1 describes a cooling apparatus for cooling a heat-generating element such as a central processing unit (CPU).

A cooling system for power electronics is provided as recited in claim 1. Further embodiments are recited in the dependent claims.

The present invention will now be described by way of example with reference to the accompanying drawings. In the drawings:
Figure 1 shows a standard cooling jacket for longitudinal cooling fluid flow;
Figure 2 shows an exploded view of an example of the present invention;
Figure 3 shows a schematic cross section through a cooling module;
Figure 4 shows a schematic plan view of a cooling module with mounted power modules;
Figure 5 shows a schematic cross section through a twin cooling chamber cooling module;
Figure 6 shows a schematic representation of the cooling flow through a cooling module;
Figure 7 shows a perspective view of a cooling system; and
Figures 8a and 8b shows an alternative form of flow distributor.

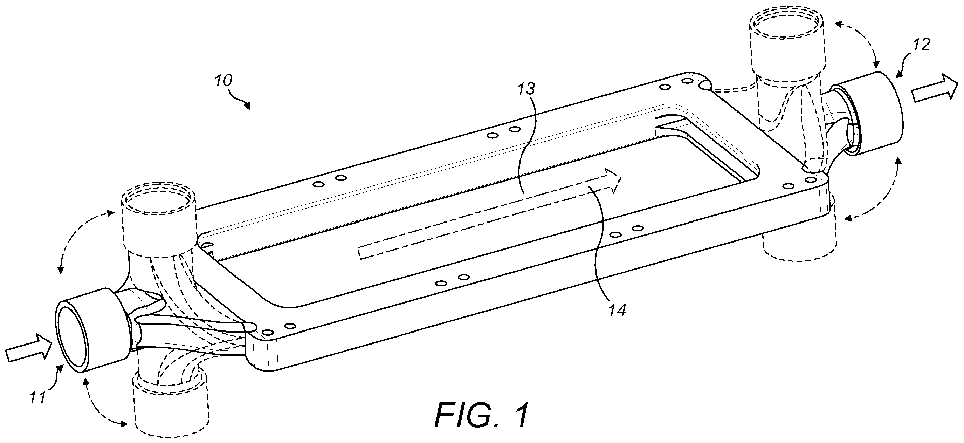

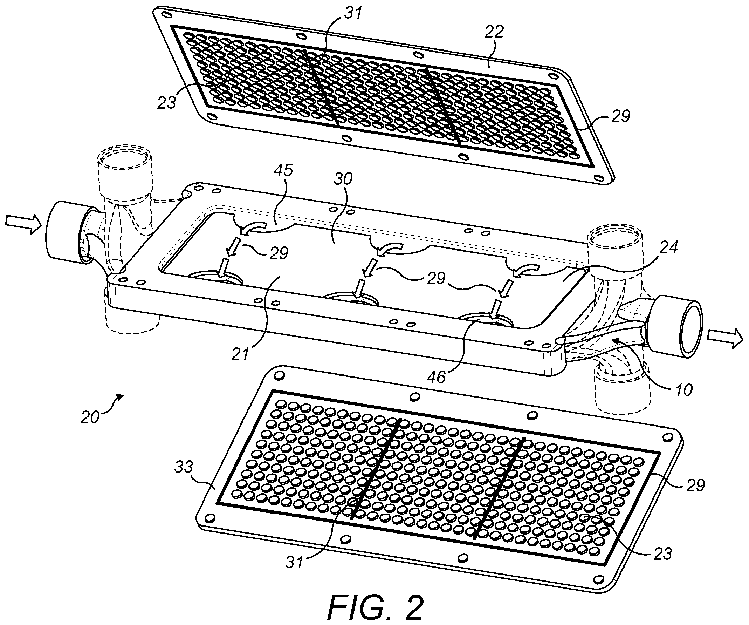

Figure 1 shows a cooling jacket 10 of a standard design having an inlet 11 and an outlet 12. The inlet and/or outlet may be oriented along the longitudinal axis of the cooling jacket (as shown in solid line in Figure 1) or may have a different orientation such as perpendicular to the longitudinal axis (as shown in dotted line in Figure 1). The inlet and /or outlet may comprise one, two or more individual flow paths - one is shown in solid line, two are shown in dotted line. The inlet 11 receives cooling fluid and distributes the fluid into a cooling chamber 13. The cooling fluid passes longitudinally along the cooling chamber 13 and then passes out of the cooling chamber 13 via outlet 12. The outlet cooling fluid is warmer than the inlet cooling fluid because heat is transferred into the cooling fluid due to electronic circuitry/power modules as described in relation to Figure 2. Arrow 14 indicates not only the direction of the cooling fluid flow, but also represents an increasing temperature gradient from the inlet to the outlet.

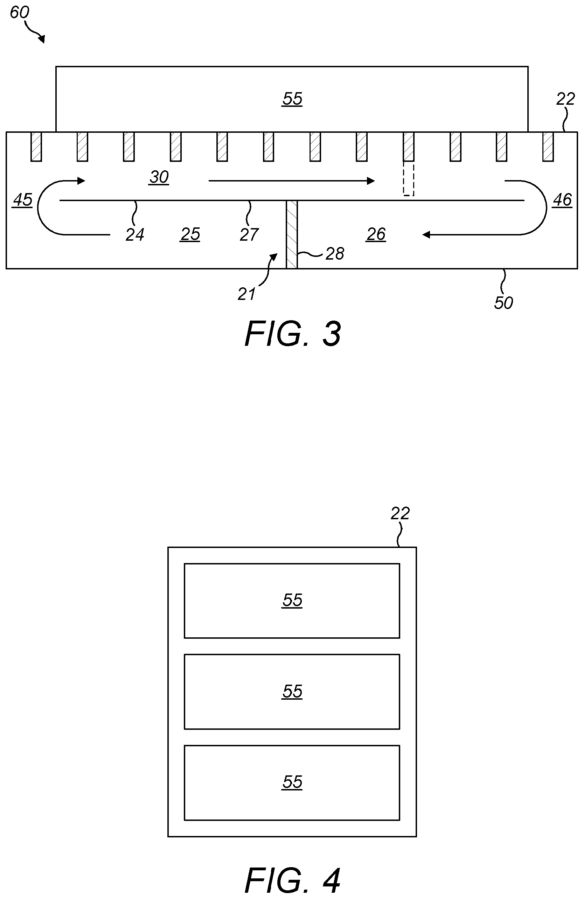

Figure 2 shows an exploded view of a twin cooling module 20 according to the present invention. The cooling jacket 10 of Figure 1 is substantially unchanged, but in this example, the chamber 13 contains a flow distributor 21 (see Figures 3, 4 and 6) which alters the flow of the cooling fluid when compared to the arrangement of Figure 1. The flow distributor 21 is a substantially planar flow plate 24 having inlet 25 and outlet 26 channels on a first face 27. A divider 28 is provided between the inlet 25 and outlet 26 channels. The arrows 29 of Figure 2 illustrate how the cooling fluid flow is caused to travel across the cooling chamber from side to side, rather than longitudinally. Walls 31 may be provided to divide the pin fin plate into independent chambers typically associated/aligned with a respective power module. The walls 31 preferably have the same height as the pin fins. This creates a wider, but shorter, flow path across a face of the cooling module leading to reduced temperature gradient across the cooling chamber. This flow will be explained in greater details with reference to later figures.

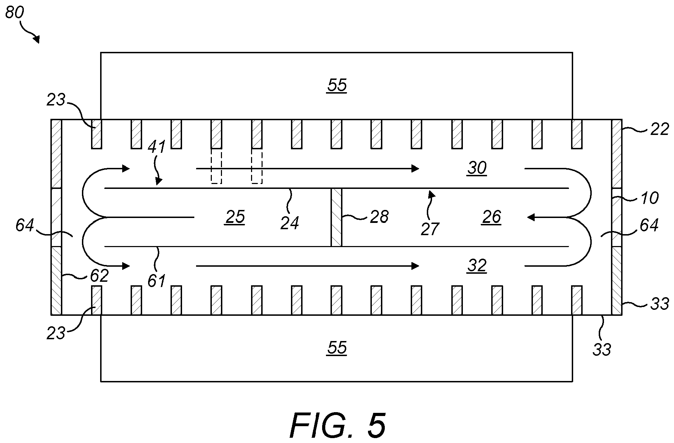

The cooling jacket 10 and the flow distributor 21 are closed on the upper (in Figure 2) face by a first pin fin plate 22 defining a main cooling chamber 30. The first fin plate 22 is provided with an array of fins 23 which, when the pin fin plate 22 is fixed to the cooling jacket, extend into the main cooling chamber 30 such that cooling fluid can flow around the fins and take up heat therefrom. The fins 23 are shorter than would typically be used on a conventional fin plate, and are preferably 1mm, rather the more normal 4mm in length. An advantage of the low height is that, due to the relatively larger width, the pressure drop is reduced. The fins may touch face 41 of the flow distributor or may be spaced therefrom. If spaced, the spacing is preferably relatively smaller to ensure maximum coolant flow around the cooling pins. This also helps to minimise the overall height of the cooling module. Figures 3 and 5 illustrate that the height of the fins could be the full depth (dotted lines) of the cooling chamber or may extend only over a part of the depth. Power modules or other electronics (see Figures 3 to 5, 7) can be affixed to the opposite face of the plate 22 and transfer heat to the pins 23. A seal 29, in this example a sealing gasket, ensures coolant does not leak. The sealing gasket is typically provided within a groove in the fin plate 22 which helps to minimise the overall height of the cooling module.

A second fin plate 33 defines a second main cooling chamber 32 and is shown in greater detail in Figure 5. The second pin fin plate 33, is typically of the same form as first fin plate 22, and can then be affixed to the opposite side of the cooling jacket 10.

The form and effect of the flow distributor 21 is shown more clearly in Figures 3, 5 and 6.

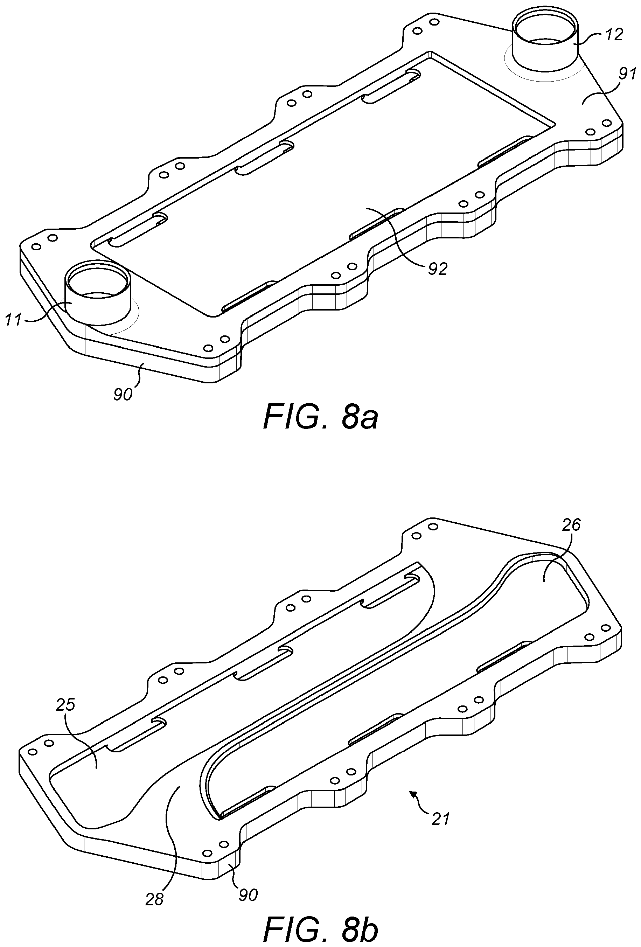

Figure 3 is a cross section through a single sided cooling module 60 and illustrates the fluid flow around the flow distributor. The flow distributor 21 has a substantially planar flow plate 24 having a first face 27 and a second face 41. A divider 28 extends away from the first face and, together with a closure 50, defines the inlet channel 25 and the outlet channel 26. The closure 50 may be integrally formed with the divider, such that the flow distributor has an upper planar element 24, the divider 28 and a lower planar element 50. Alternatively, the flow plate 24 and the divider may be integral, with the closure 50 separate, or indeed the closure 50 and the flow divider could be integral, with the flow plate 24 being a separate element (as shown in Figure 8). The inlet channel 25 receives cooling fluid from the inlet 11 and directs it towards inlet flow passages 45 which extend between the inlet channel 25 and the main cooling chamber 30. The cooling fluid then passes across the main cooling chamber 30, through outlet flow passages 46 and back into the outlet channel 26. The cooling flow then passes along the outlet channel and exits via outlet 12.

The divider 28 takes, according to the present invention, the form of an S-shaped wall. The S-shape is when seen in plan view, i.e. looking perpendicular to the flow plate 24. It is beneficial for there to be an S-shaped wall on the inside of each of the inlet 25 and outlet 26 channels as can be seen in the example of Figure 8. As shown in Figure 3, the divider preferably takes the form of a narrow wall and this is beneficial as it allows the greatest size to the inlet and outlet channels, thereby maximising the amount of cooling flow. Furthermore, the S-shape ensures that the inlet flow passages 31 that are further away from the inlet experience substantially the same flow rates and pressures as the flow passages nearer the inlet. The S-shape may be a continuous curve, or may include one or more straight sections in the middle. An alternative form for the flow distributor is shown in Figure 8.

As can be seen in Figure 4, power modules 55 are mounted on the outside of fin plate 22 and these can typically lie across the cooling module such that the cooling flow within the cooling module is along the length of the power modules. In this way, the cooling module provides parallel cooling of the various power modules, as each one experiences substantially the same cooling effect. Whilst three of each of flow passages 45, 46 are shown in Figure 2, a different number could be provided. An equal number on each side is beneficial to maintain a series of substantially parallel flow streams. It may be that the number of flow passages on each side corresponds to the number of power modules to be cooled. In this arrangement, the power modules may be aligned with respective pairs of flow passages. The power modules may mounted individually, or may be part of a single structure which is then mounted onto the fin plate 22. Power modules may be mounted on either or both fin plates. The cooling flow is preferably along an axis of the or each power modules, the axis typically being a longitudinal axis of the power module.

The flow passages 45, 46 are, in Figure 2, provided by respective openings or recesses in the edge of the flow plate 24 in the flow distributor 21. Alternatively and/or additionally, the flow passages may include flow pathways (not shown) within the cooling jacket or even passages extending through to the cooling jacket and then back into the main cooling chamber. The flow passages may include openings in other components.

A twin cooling chamber cooling module 80 is shown in Figure 5 in which, instead of the closure 50, a second fin plate 33 is provided. The equivalent function of the closure 50 is provided by a further planar element 61 which, together with the plate 24, sandwich the divider 28. This second fin plate may be identical to fin plate 22 and defines, along with the further planar element 61, the second main cooling chamber 32. No second divider is required. Corresponding second inlet 63 and second outlet 64 flow passages are formed to allow cooling fluid flow from the inlet channel 25 to pass across the second main cooling chamber 32 in the same manner as described above in relation to main cooling chamber 30. The second inlet 63 and second outlet 64 flow passages may take the matching form to the first inlet 25 and first outlet 26 passages, and may be the same in number. However, they could also be different in number or form, depending upon the cooling requirement from the second main cooling chamber 32.

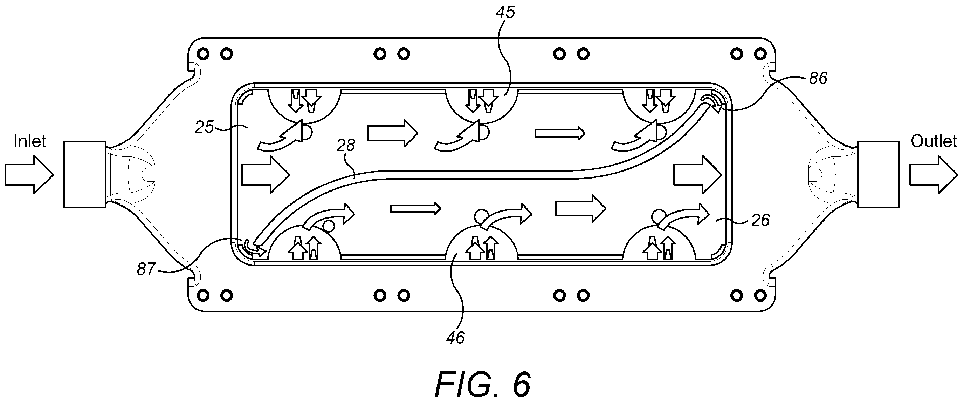

Figure 6 illustrates the flow paths through the twin cooling chamber module 80 of Figure 5. The inlet coolant flow is received into the wider end of the inlet chamber 25 and is caused to flow towards the narrower end. As the flow path narrows along the inlet chamber, part of the coolant flow is caused to enter the inlet flow passages 45 but due to the reducing size of the inlet channel, the pressure of the remaining coolant in the inlet channel does not alter significantly. This occurs all along the inlet channel, thereby ensuring that the flow through each inlet flow passage is substantially identical in pressure and flow rate. This ensures that the cooling module can provide an even cooling effect across its length. The coolant then flows into, and across the width of, each of the main cooling chambers 30, 32 before passing into respective outlet flow passages 46 and then recombining in the outlet flow channel 26. The widening of the outlet flow channel towards the outlet helps to maintain a constant flow rate and pressure in the outlet coolant flow. Divider holes 86 and 87 can be provided in the divider, typically at or adjacent one or both ends of the divider. The effect of the hole(s) is to eliminate vortex generation and therefore regions of static flow. Such static flow is not refreshed by new coolant and so hot spots could form. The holes are sized to permit a small amount of coolant flow directly across the divider to prevent vortex formation, but the bulk of the coolant flow is still caused to flow along the inlet channel and through the flow passages so as to be used for cooling within the cooling chamber(s).

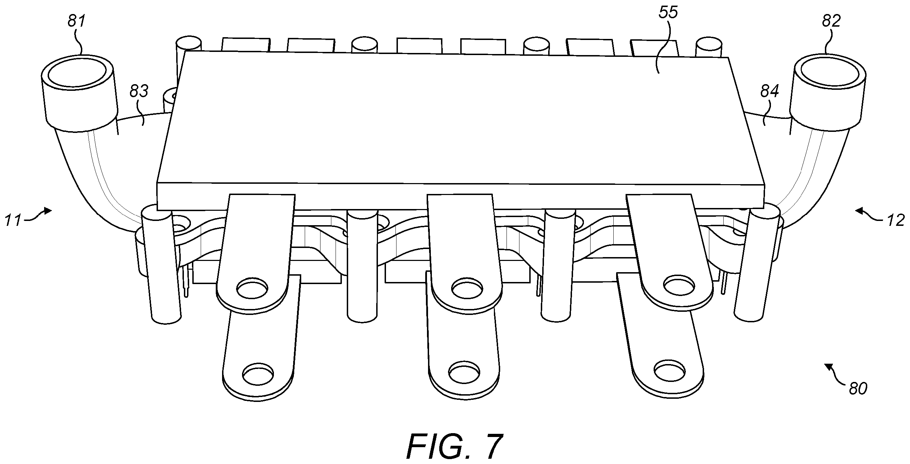

Figure 7 shows an alternative form of the twin cooling chamber module 80 and, in particular, this figure shows the inlet 11 and outlet 12. In this example, the inlet includes a substantially circular inlet opening 81 into which coolant flows, the opening leading to a diverging inlet manifold 83 which allows the inlet flow to enter the inlet channel 25 across substantially the whole width of the channel. This ensures a smoother flow of inlet cooling fluid with fewer recirculating eddies and the like which can adversely affect the cooling profile of the cooling module. The outlet has a similar form, with a converging outlet manifold 84 receiving coolant fluid across substantially the whole width of the outlet channel 26 and directing it to the outlet opening 82. The use of substantially the whole width ensures that cooling fluid does not become trapped in a region of the outlet channel, which would lead to areas that do not provide the correct level of cooling.

The gradual change in the cross section of the flow path, within the inlet and outlet manifolds and within the inlet and outlet channels minimises regions with high pressure drop, thereby resulting in smoother cooling fluid flow. Other factors that assist in minimising pressure drop within the system include no sharp corners or significant obstacles within the flow path, and the large width of the cooling flow within the main cooling chambers relative to distance the flow travels across the cooling chambers.

Figures 8a and 8b shows an alternative form to the flow distributor 21, being used in a single cooling chamber cooling module. The form shown here could be used in a twin cooling chamber cooling module as well. In this example, the cooling jacket is formed from two parts, a lower part 90 which includes an integrally formed flow distributor 21 defining the inlet 25 and outlet 26 channels, and an upper section 91 which includes the coolant inlet 11 and outlet 12 and which also includes a central planar section 92 which functions in a similar manner to the flow plate of Figure 3. The divider 28 in this example is not a narrow wall along the entire length, but rather has a varying width. The divider still provides an S-shape to the inner wall of each of the inlet 25 and outlet 26 channels. Although not shown, the divider holes 86, 87 of Figure 6 could still be incorporated in the arrangement of Figure 8.

Figure 8a shows the upper 91 and lower 90 parts joined together, whereas Figure 8b shows only lower part 90 and illustrates the inlet 25 and outlet 26 channels.

The flow distributor 21 could be formed integrally with the cooling jacket 10 or within the lower section of Figure 8, and may be formed by 3-D printing or casting. Alternatively, they may be separate elements, in which case, the flow distributor is preferably mounted by way of an interference fit within the cooling jacket. One or more resilient elements (not shown) may be placed between the cooling jacket and the flow distributor to assist with the interference fit.

## Claims

1. A cooling system for power electronics, the system comprising:
a cooling module (20) having inlet (11) and outlet (12) ends, an inlet side with an inlet channel (25) for receiving, at the inlet end, a flow of cooling fluid and an outlet side having an outlet channel (26) through which, at the outlet end, outlet flow exits the system, the inlet and outlet channels being on a first face (27) of the cooling module; and
a cooling plate mounted on the other face of the cooling module and forming with the cooling module a cooling chamber (30) in fluid communication with the inlet and outlet flow channels via a plurality of cooling fluid passages (45, 46) located on opposite sides of the cooling module, such that, in use, flow of cooling fluid in the cooling chamber is from the inlet side to the outlet side;
wherein the system further comprises: a divider (28) between the inlet and outlet channels, wherein the divider defines an S-shape to a portion of the inlet and/or the outlet flow channels, and **characterised in that**
the divider includes at least one opening at or adjacent an end of the divider (86, 87) to permit flow between the inlet side and the outlet side.

2. A cooling system according to claim 1, wherein the cooling module includes a cooling jacket (10) and a coolant flow distributor (21).

3. A cooling system according to claim 2, wherein the cooling jacket (10) and coolant flow distributor (21) are integrally formed.

4. A cooling system according to claim 2, wherein the cooling jacket (10) and coolant flow distributor (21) are discrete elements.

5. A cooling system according to claim 1, wherein the S-shaped portion is opposite the cooling fluid passages (45, 46).

6. A cooling system according to any of the preceding claims, wherein the inlet and outlet channels (25, 26) are on the same face of the cooling module.

7. A cooling system according to any of the preceding claims, further comprising a plurality of cooling fluid passages (45, 46) on each of the inlet and outlet sides.

8. A cooling system according to any of the preceding claims, wherein the cooling fluid passages provide substantially parallel flow paths across the cooling chamber.

9. A cooling system according to any of the preceding claims, wherein the inlet and outlet channels extend between the inlet and outlet ends providing substantially longitudinal flow and wherein, in use, cooling fluid flow in the cooling chamber is substantially perpendicular to the inlet and outlet channel flow.

10. A cooling system according to any of the preceding claims, wherein the cooling plate is on a first face (27) of the cooling module and a second cooling plate is on a second face (41) of the cooling module.

11. A cooling system according to claim 10, further comprising a second set of flow passages for supplying cooling fluid to the second cooling plate.

12. A cooling system according to any of the preceding claims, wherein the or each cooling chamber has a cooling face opposite the cooling module.

13. A cooling system according to any of the preceding claims, wherein the or each cooling plate includes one or more internal dividing walls (31) for splitting the respective cooling chamber into multiple sections with a plurality of cooling fins (23) extending into each section.

14. A power electronics system comprising a cooling system according to any of the preceding claims, and power electronics to be cooled by the cooling system mounted on a cooling face of the cooling chamber opposite the cooling module.

15. A power electronics system according to claim 14, wherein the power electronics comprises a plurality of power modules, wherein two or more of the flow passages align with a power module such that cooling fluid flows parallel to an axis of the power module.

## Patentansprüche

1. Kühlsystem für Leistungselektronik, wobei das System umfasst:
ein Kühlmodul (20) mit Einlass- (11) und Auslassenden (12), einer Einlassseite mit einem Einlasskanal (25) zum Aufnehmen eines Kühlflüssigkeitsstroms am Einlassende und einer Auslassseite mit einem Auslasskanal (26), durch den der Auslassstrom am Auslassende das System verlässt, wobei sich die Einlass- und Auslasskanäle auf einer ersten Fläche (27) des Kühlmoduls befinden; und
eine Kühlplatte, die auf der anderen Fläche des Kühlmoduls montiert ist und mit dem Kühlmodul eine Kühlkammer (30) bildet, die über eine Vielzahl von Kühlflüssigkeitskanälen (45, 46), die sich auf gegenüberliegenden Seiten des Kühlmoduls befinden, in Flüssigkeitsverbindung mit den Einlass- und Auslassströmungskanälen steht, so dass im Gebrauch die Kühlflüssigkeit in der Kühlkammer von der Einlassseite zur Auslassseite strömt;
wobei das System ferner umfasst: eine Trennwand (28) zwischen dem Einlass- und dem Auslasskanal, wobei die Trennwand eine S-Form für einen Teil der Einlass- und/oder der Auslassströmungskanäle eingrenzt, und **dadurch gekennzeichnet, dass** die Trennwand mindestens eine Öffnung an oder neben einem Ende der Trennwand (86, 87) aufweist, um eine Strömung zwischen der Einlassseite und der Auslassseite zu ermöglichen.

2. Kühlsystem gemäß Anspruch 1, wobei das Kühlmodul einen Kühlmantel (10) und einen Kühlmittelstromverteiler (21) beinhaltet.

3. Kühlsystem gemäß Anspruch 2, wobei der Kühlmantel (10) und der Kühlmittelstromverteiler (21) einstückig ausgebildet sind.

4. Kühlsystem gemäß Anspruch 2, wobei der Kühlmantel (10) und der Kühlmittelstromverteiler (21) diskrete Elemente sind.

5. Kühlsystem gemäß Anspruch 1, wobei der S-förmige Abschnitt den Kühlflüssigkeitskanälen (45, 46) gegenüberliegt.

6. Kühlsystem gemäß einem der vorhergehenden Ansprüche, wobei sich die Einlass- und Auslasskanäle (25, 26) auf derselben Fläche des Kühlmoduls befinden.

7. Kühlsystem gemäß einem der vorhergehenden Ansprüche, das ferner eine Vielzahl von Kühlflüssigkeitskanälen (45, 46) auf jeder der Einlass- und Auslassseiten umfasst.

8. Kühlsystem gemäß einem der vorhergehenden Ansprüche, wobei die Kühlflüssigkeitskanäle im Wesentlichen parallele Strömungswege durch die Kühlkammer bieten.

9. Kühlsystem gemäß einem der vorhergehenden Ansprüche, wobei sich die Einlass- und Auslasskanäle zwischen den Einlass- und Auslassenden erstrecken und im Wesentlichen eine Längsströmung bieten, und wobei im Gebrauch die Kühlflüssigkeitsströmung in der Kühlkammer im Wesentlichen senkrecht zur Strömung in den Einlass- und Auslasskanälen verläuft.

10. Kühlsystem gemäß einem der vorhergehenden Ansprüche, wobei sich die Kühlplatte auf einer ersten Fläche (27) des Kühlmoduls und eine zweite Kühlplatte auf einer zweiten Fläche (41) des Kühlmoduls befindet.

11. Kühlsystem gemäß Anspruch 10, das ferner einen zweiten Satz Strömungskanäle zum Versorgen der zweiten Kühlplatte mit Kühlflüssigkeit umfasst.

12. Kühlsystem gemäß einem der vorhergehenden Ansprüche, wobei die oder jede Kühlkammer eine dem Kühlmodul gegenüberliegende Kühlfläche aufweist.

13. Kühlsystem gemäß einem der vorhergehenden Ansprüche, wobei die oder jede Kühlplatte eine oder mehrere innere Trennwände zum Aufteilen der jeweiligen Kühlkammer in mehrere Abschnitte einschließt.

14. Leistungselektroniksystem, das ein Kühlsystem gemäß einem der vorhergehenden Ansprüche und eine durch das Kühlsystem zu kühlende Leistungselektronik umfasst, die auf einer dem Kühlmodul gegenüberliegenden Kühlfläche der Kühlkammer montiert ist.

15. Leistungselektroniksystem gemäß Anspruch 14, wobei die Leistungselektronik eine Vielzahl von Leistungsmodulen umfasst, wobei zwei oder mehr der Strömungskanäle an einem Leistungsmodul ausgerichtet sind, so dass Kühlflüssigkeit parallel zu einer Achse des Leistungsmoduls fließt.

## Revendications

1. Système de refroidissement pour un appareil électronique de puissance, le système comprenant :
un module de refroidissement (20) comportant des extrémités d'entrée (11) et de sortie (12), un côté entrée avec un canal d'entrée (25) pour recevoir, au niveau de l'extrémité d'entrée, un écoulement de fluide de refroidissement et un côté sortie comportant un canal de sortie (26) par lequel, au niveau de l'extrémité de sortie, l'écoulement de sortie sort du système, les canaux d'entrée et de sortie étant sur une première face (27) du module de refroidissement ; et
une plaque de refroidissement montée sur l'autre face du module de refroidissement et formant avec le module de refroidissement une chambre de refroidissement (30) en communication fluidique avec les canaux d'écoulement d'entrée et de sortie via une pluralité de passages de fluide de refroidissement (45, 46) situés sur des côtés opposés du module de refroidissement, de telle sorte que, en utilisation, l'écoulement du fluide de refroidissement dans la chambre de refroidissement s'effectue du côté entrée vers le côté sortie ;
dans lequel le système comprend en outre : un séparateur (28) entre les canaux d'entrée et de sortie, dans lequel le séparateur définit une forme de S pour une partie des canaux d'écoulement d'entrée et/ou de sortie, et **caractérisé en ce que**
le séparateur comprend au moins une ouverture au niveau de ou adjacent à une extrémité du séparateur (86, 87) pour permettre l'écoulement entre le côté entrée et le côté sortie.

2. Système de refroidissement selon la revendication 1, dans lequel le module de refroidissement comprend une chemise de refroidissement (10) et un distributeur d'écoulement de liquide de refroidissement (21).

3. Système de refroidissement selon la revendication 2, dans lequel la chemise de refroidissement (10) et le distributeur d'écoulement de liquide de refroidissement (21) sont formés d'un seul tenant.

4. Système de refroidissement selon la revendication 2, dans lequel la chemise de refroidissement (10) et le distributeur d'écoulement de liquide de refroidissement (21) sont des éléments distincts.

5. Système de refroidissement selon la revendication 1, dans lequel la partie en forme de S est opposée aux passages de fluide de refroidissement (45, 46).

6. Système de refroidissement selon l'une quelconque des revendications précédentes, dans lequel les canaux d'entrée et de sortie (25, 26) se trouvent sur la même face du module de refroidissement.

7. Système de refroidissement selon l'une quelconque des revendications précédentes, comprenant en outre une pluralité de passages de fluide de refroidissement (45, 46) sur chacun des côtés d'entrée et de sortie.

8. Système de refroidissement selon l'une quelconque des revendications précédentes, dans lequel les passages de fluide de refroidissement fournissent des trajets d'écoulement sensiblement parallèles à travers la chambre de refroidissement.

9. Système de refroidissement selon l'une quelconque des revendications précédentes, dans lequel les canaux d'entrée et de sortie s'étendent entre les extrémités d'entrée et de sortie, fournissant un écoulement sensiblement longitudinal et dans lequel, en utilisation, l'écoulement de fluide de refroidissement dans la chambre de refroidissement est sensiblement perpendiculaire à l'écoulement des canaux d'entrée et de sortie.

10. Système de refroidissement selon l'une quelconque des revendications précédentes, dans lequel la plaque de refroidissement se trouve sur une première face (27) du module de refroidissement et une seconde plaque de refroidissement se trouve sur une seconde face (41) du module de refroidissement.

11. Système de refroidissement selon la revendication 10, comprenant en outre un second ensemble de passages d'écoulement pour fournir du fluide de refroidissement à la seconde plaque de refroidissement.

12. Système de refroidissement selon l'une quelconque des revendications précédentes, dans lequel la ou chaque chambre de refroidissement comporte une face de refroidissement opposée au module de refroidissement.

13. Système de refroidissement selon l'une quelconque des revendications précédentes, dans lequel la ou chaque plaque de refroidissement comprend une ou plusieurs parois de séparation internes pour diviser la chambre de refroidissement respective en plusieurs sections.

14. Système électronique de puissance comprenant un système de refroidissement selon l'une quelconque des revendications précédentes, et un appareil électronique de puissance devant être refroidi par le système de refroidissement monté sur une face de refroidissement de la chambre de refroidissement opposée au module de refroidissement.

15. Système électronique de puissance selon la revendication 14, dans lequel l'appareil électronique de puissance comprend une pluralité de modules de puissance, dans lequel deux passages d'écoulement ou plus s'alignent avec un module de puissance de telle sorte que le fluide de refroidissement s'écoule parallèlement à un axe du module de puissance.
